(19) Europäisches Patentamt
European Patent Office
Office européen des brevets

(11) Veröffentlichungsnummer : **0 388 754 B1**

(12) # EUROPÄISCHE PATENTSCHRIFT

(45) Veröffentlichungstag der Patentschrift :
**12.08.92 Patentblatt 92/33**

(51) Int. Cl.[5] : **C23C 16/40**, H01L 39/24, C04B 35/00

(21) Anmeldenummer : **90104671.4**

(22) Anmeldetag : **12.03.90**

(54) **Verfahren zur Herstellung von Schichten aus einem oxidkeramischen Supraleitermaterial auf einem Substrat mittels CVD-Prozess.**

(30) Priorität : **22.03.89 DE 3909406**

(43) Veröffentlichungstag der Anmeldung :
**26.09.90 Patentblatt 90/39**

(45) Bekanntmachung des Hinweises auf die Patenterteilung :
**12.08.92 Patentblatt 92/33**

(84) Benannte Vertragsstaaten :
**AT CH DE FR GB IT LI NL SE**

(56) Entgegenhaltungen :
**APPLIED PHYSICS LETTERS, Band 53, Nr. 20, 16. Mai 1988, Seiten 1743-1745, New York, US; A.D. BERRY et al.: "Formation of highTc superconducting films by organometallic chemical vapor deposition"**
**JAPANESE JOURNAL OF APPLIED PHYSICS/-PART 2: LETTERS, Band 27, Nr. 9, September 1988, Seiten L1683-L1685, Tokyo, JP; K.SHINOHARA et al.: "Preparation of Y-Ba-Cu-O superconducting thin film by chemical vapor deposition"**

(56) Entgegenhaltungen :
**APPLIED PHYSICS LETTERS, Band 53, Nr. 18, 31. Oktober 1988, Seiten 1756-1758, American Institute of Physics, New York, US;A.J. PANSON et al.: "Chemical vapor deposition of YBa2Cu3O7 using metalorganic chelate precursors"**
**JOURNAL OF CRYSTAL GROWTH, Band 92, Nr. 1-2, Oktober 1988, Seiten 344-347, Elsevier Science Publishers B.V., Amsterdam, NL;A.D. BERRY et al.: "Growth of superconducting thin films of bismuth-strontium-calcium-copper oxide by organometallic chemical vapor-deposition"**
**APPLIED PHYSICS LETTERS, Band 53, Nr. 18, 31. Oktober 1988, Seiten 1750-1752, American Institute of Physics, New York, US; J.ZHAO et al.: "Organometallic chemical vapor deposition of high Tc superconducting films using a volatile, fluorocarbon-basedprecursor"**

(73) Patentinhaber : **SIEMENS AKTIENGESELLSCHAFT**
**Wittelsbacherplatz 2**
**W-8000 München 2 (DE)**

(72) Erfinder : **Müller, Alfred, Dr.**
**Fichtestrasse 25**
**W-8520 Erlangen (DE)**

EP 0 388 754 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Gegenstand der nicht-vorveröffentlichten deutschen Patentanmeldung P 37 34 069.7 vom 8.10.1987 (entsrpricht WO-A-89/03594, veröffeutlicht aus 20.04.1989) ist ein Verfahren zur Abscheidung mindestens einer Schicht aus einem oxidkeramischen Supraleitermaterial eines metallische Komponenten und Sauerstoff enthaltenden Stoffsystems mit hoher Sprungtemperatur auf einem Substrat. Dabei sollen die folgenden Verfahrensschritte vorgesehen werden:

1) Als Ausgangsmaterialien werden jeweils mindestens eine verdampfbare Verbindung jeder der metallischen Komponenten des Stoffsystems vorgesehen,

2) jede dieser Ausgangsverbindungen wird bei einer vorbestimmten Temperatur und mit einem vorbestimmten Partialdruck verdampft und mittels eines Trägergasstromes so dosiert, daß bei einem anschließenden Zusammenführen der drei so gebildeten Gasströme zu einem Gasgemisch ein Verhältnis der metallischen Komponenten eingestellt wird, wie es zur Ausbildung des Supraleitermaterials benötigt wird, und

3) zur Abscheidung des gewünschten Supraleitermaterials werden die Reaktionsbedingungen für eine Reaktion der oder mit den verdampften Ausgangsverbindungen durch Energiezufuhr eingestellt.

Gemäß einer bevorzugten Ausführungsform dieses Verfahrens soll dem Gasgemisch aus den die Ausgangsverbindungen enthaltenden Gasströmen mittels eines Trägergases mindestens ein weiterer gasförmiger reaktionsfähiger Partner zugeführt werden, der mit den verdampften Ausgangsverbindungen unter Bildung des Supraleitermaterials reagieren kann.

Es sind supraleitende Metalloxidverbindungen auf Basis eines metallische Komponenten und Sauerstoff enthaltenden Stoffsystems bekannt, die sich durch so hohe Sprungtemperaturen $T_c$ auszeichnen, daß eine Kühlung mit flüssigem Stickstoff von etwa 77 K bei Normaldruck ermöglicht wird. Entsprechende Stoffsysteme sind insbesondere Y-Ba-Cu-O, Bi-Sr-Ca-Cu-O und Tl-Ba-Ca-Cu-O. Dünne Schichten oder Filme aus diesen Materialien lassen sich vielfach durch spezielle PVD (Physical Vapor Deposition)-Prozesse wie z.B. durch Aufdampfen oder Aufsputtern herstellen. Daneben ist bereits versucht worden, Schichten aus diesen Materialien auch mittels besonderer CVD(Chemical Vapor Deposition)-Prozesse auf Substraten abzuscheiden. Das in der eingangs genannten Patentanmeldung beschriebene Verfahren ist hierunter zu rechnen.

Gemäß diesem vorgeschlagenen Verfahren werden als Ausgangsmaterialien jeweils mindestens eine verdampfbare Verbindung jeder der metallischen Komponenten des Stoffsystems vorgesehen. Als Ausgangsverbindungen können insbesondere Chelate, vorzugsweise ß-Diketonate, der metallischen Komponenten verwendet werden. Jede dieser drei Ausgangsverbindungen wird dann bei einer vorbestimmten Temperatur und einem vorbestimmten Partialdruck verdampft. Die so gebildeten Gasströme werden dann jeweils mittels eines besonderen Trägergasstromes, beispielsweise aus Argon, so dosiert und zu einem Gasgemisch zusammengeführt, daß ein Verhältnis der metallischen Komponenten erhalten wird, wie es zur Ausbildung des Supraleitermaterials benötigt wird. Dabei kann dem Gasgemisch mittels eines Trägergasstromes mindestens ein weiterer gasförmiger Reaktionspartner zugeführt werden, der mit den verdampften Ausgangsverbindungen unter Bildung des Supraleitermaterials reagieren kann. Als hierfür geeignete Reaktionspartner sind insbesondere verdampftes (gasförmiges) Wasser oder Sauerstoff-Gas vorgeschlagen. Zur Abscheidung des gewünschten Supraleitermaterials werden schließlich die Reaktionsbedingungen für eine Reaktion der oder mit den gasförmigen Ausgangsverbindungen und dem Reaktionspartner durch Energiezufuhr eingestellt. Die Energiezufuhr läßt sich insbesondere mittels einer Temperaturerhöhung vornehmen. Die Abscheidung des Supraleitermaterials kann dabei in einer Reaktion der oder mit den Ausgangsverbindungen und dem Reaktionspartner durch Hydrolyse der Ausgangsverbindungen und Dehydratisierung der dabei gewonnenen Hydroxide oder auch durch Oxidation der Ausgangsverbindungen erfolgen.

Aufgabe der vorliegenden Erfindung ist es nun, das vorgeschlagene Verfahren dahingehend auszugestalten, daß eine zumindest zeitweilige Verringerung der Reaktionstemperatur und eine Erhöhung der Reaktionsgeschwindigkeit erreicht werden.

Diese Aufgabe wird erfindungsgemäß dadurch gelöst, daß der dem Gasgemisch zugeführte gasförmige Reaktionspartner Ammoniak oder ein organisches Amin zumindest enthält.

Die mit dieser Ausgestaltung des Verfahrens verbundenen Vorteile sind insbesondere darin zu sehen, daß eine Hydrolysereaktion zur Ausbildung des Supraleitermaterials begünstigt, d.h. bei verhältnismäßig niedriger Temperatur mit verhältnismäßig hoher Reaktionsgeschwindigkeit ermöglicht wird. Eine entsprechende Wirkung zeigen auch organische Amine, insbesondere auch bei einer Hydrolyse von Diketonaten der metallischen Ausgangskomponenten.

Vorteilhafte Ausgestaltungen des erfindungsgemäßen Verfahrens gehen aus den Unteransprüchen hervor.

Die Erfindung wird nachfolgend anhand eines Ausführungsbeispieles noch weiter erläutert, wobei auf die

Zeichnung Bezug genommen wird. In Figur 1 ist schematisch der Ablauf zu einer erfindungsgemäßen Beschichtung von Substraten großer Länge mit einer speziellen supraleitenden Oxidkeramik angedeutet. In den Figuren 2 und 3 sind jeweils in einem Diagramm Dampfdruck-Temperatur-Kurven bzw. Umsatz-Temperatur-Kurven einzelner Ausgangskomponenten für das erfindungsgemäße Verfahren wiedergegeben.

Bei dem erfindungsgemäßen Verfahren wird von der Offenbarung der genannten DE-Patentanmeldung P 37 34 069.7 (entspricht WO-A-89/03594) ausgegangen. Mit dem Verfahren sind ein- oder mehrlagige Schichten mit Schichtdicken bis über 10 µm aus bekannten supraleitenden Hoch-$T_c$-Materialien (mit Sprungtemperaturen $T_c$ über 77 K) auf beliebig geformten Substraten (Trägerkörpern) auf chemischem Wege abzuscheiden. Als Ausführungsbeispiel sei die Herstellung einer Schicht aus dem bekannten supraleitenden Hoch-$T_c$-Material $YBa_2Cu_3O_{7-x}$ (mit $0 < x < 0,5$) zugrundegelegt. Dieses Material ist dem vierkomponentigen Stoffsystem Me1-Me2-Cu-O zuzurechnen, wobei allgemein die metallische Komponente Me1 ein Element aus der Gruppe der Seltenen Erdmetalle (einschließlich Y) und die metallische Komponente Me2 ein Element aus der Gruppe der Erdalkalimetalle zumindest enthalten.

Das erfindungsgemäße Verfahren gliedert sich gemäß einer vorteilhaften Ausgestaltung im wesentlichen in vier Verfahrensschritte unter, auf die nachfolgend unter Zugrundelegung des Ausführungsbeispiels im einzelnen eingegangen wird.

1. Verfahrensschritt

(Bereitstellung verdampfbarer Ausgangskomponenten)

Da sich die drei metallischen Komponenten Y, Ba und Cu des gewünschten supraleitenden Materials im Rahmen des Systems Y-Ba-Cu-O insgesamt nur schwer verdampfen lassen, werden als Ausgangsmaterialien verdampfbare Verbindungen dieser Elemente vorgesehen. Hierfür sind unter den organischen Verbindungen der Ausgangsmetalle insbesondere β-Diketon-Chelate geeignet. Für das erfindungsgemäße Verfahren sind insbesondere die Kupfer-Chelate $Cu(C_5H_7O_2)_2$ und $Cu(C_{11}H_{19}O_2)_2$ sowie die Y- und Ba-Chelate $Y(C_{11}H_{19}O_2)_3$ bzw. $Ba(C_{11}H_{19}O_2)_2$ von 2,2,6,6-Tetramethyl-heptan-3,5-dion zu verwenden. Die Chelate sind entweder im Handel zu erhalten oder lassen sich in bekannter Weise aus ß-Diketonen, Acetylaceton oder Tetramethyl-heptan-dion, und den Metallsalzen herstellen.

2. Verfahrensschritt

(Verdampfen und Dosieren)

In diesem Verfahrensschritt werden als Ausgangsmaterialien die gemäß dem ersten Verfahrensschritt gewählten drei Ausgangsverbindungen der drei metallischen Ausgangselemente Y, Ba und Cu jeweils bei einer vorbestimmten Temperatur $T_1$ bzw. $T_2$ bzw. $T_3$ jeweils in einer eigenen Verdampfungskammer verdampft. Die zu wählenden Temperaturen hängen dabei von den erforderlichen Partialdrücken der verwendeten Ausgangsverbindungen ab. Gemäß dem in Figur 1 gezeigten Schema für eine erfindungsgemäße Abscheidung einer supraleitenden Hoch-$T_c$-Oxidkeramik des Stoffsystems Y-Ba-Cu-O mittels einer chemischen Gasphasenreaktion werden die Dämpfe (Gase) der drei Ausgangsverbindungen in den Verdampfungskammern 2a bis 2c jeweils einem Trägergasstrom 3a bis 3c, z.B. aus Argon, zugemischt. Diese Zumischungen müssen so dosiert werden, daß bei einem anschließenden Zusammenführen der so entstandenen Gasströme 4a bis 4c zu einem Gasgemisch 5 in einem Mischbereich 6, z.B. einer entsprechenden Mischkammer, ein bestimmtes Verhältnis der drei metallischen Ausgangselemente zumindest annähernd eingehalten wird. Dieses Verhältnis hängt vom Grad der Umsetzung der Ausgangselemente bei einer abschließenden Reaktion unter Ausbildung und Abscheidung des gewünschten Supraleitermaterials ab. Bei einer vollständigen Umsetzung kann dieses Verhältnis in etwa dem stöchiometrischen Verhältnis der Ausgangselemente in dem Supraleitermaterial entsprechen. Dieses Dosieren ist bei dem erfindungsgemäßen Verfahren mit mehreren Komponenten, deren Eigenschaften empfindlich von der prozentualen Zusammensetzung abhängen, entscheidend. Es ist deshalb unerläßlich, daß für den zweiten Verfahrensschritt der Dampfdruck der verwendeten Ausgangsverbindungen in Abhängigkeit von der Temperatur berücksichtigt wird. Die entsprechenden Daten sind entweder bekannt oder lassen sich ohne weiteres experimentell ermitteln. In Figur 2 sind in einem Diagramm die Dampfdruckkurven p für β-Diketonate von Y, Ba und Cu wiedergegeben, wobei auf der unteren Abszisse der reziproke Wert der Temperatur als 1/T aufgetragen ist. Die zugehörigen T-Werte (in °C) sind anhand der oberen Abszisse zu erhalten. So werden z.B. für $(C_5H_7O_2)_2Cu$ in Gegenwart von Argon ein Druck p von 1 Torr bei etwa 186°C und ein Druck p von 10 Torr bei etwa 225°C ermittelt.

Gemäß dem angenommenen Ausführungsbeispiel wird das Argon über ein Gasmeßgerät durch ein mit

konstanter Temperaturzone beheiztes Glasrohr geleitet, das eine lockere Schüttung der zu verdampfenden Substanz aus einem Diketonat-Quarzwolle-Gemisch enthält. Man kann z.B. in den Verdampfergefäßen Temperaturen $T_1$ bis $T_3$ einstellen, bei denen die aus den Dampfdruck-Temperatur-Kurven zu entnehmenden Partialdrücke der Komponenten gleich sind. Diese Temperaturen liegen z.B. in einem Temperaturbereich zwischen 150°C und 300°C. Für ein Molverhältnis der Diketonate von Y, Ba und Cu im Reaktionsgemisch 11 von 1:2:3 werden dann Trägergasströme mit Flüssen im gleichen Verhältnis 1:2:3, gemessen in l/sec, vorgesehen.

3. Verfahrensschritt

(Komplettierung mit einer reaktionsfähigen Komponente)

Gemäß dem in Figur 1 gezeigten Reaktionsschema wird in dem dritten Verfahrensschritt beispielsweise in dem Mischbereich 6 oder insbesondere auch in einem diesem Mischbereich 6 nachgeordneten Bereich 7 mindestens eine weitere gasförmige Komponente beigemischt. Diese mindestens eine Komponente ist dabei so gewählt, daß sie eine Umsetzung mit den verdampften Ausgangsverbindungen unter Ausbildung bzw. Abscheidung der gewünschten supraleitenden Hoch-$T_c$-Oxidkeramik unter besonderen Bedingungen einer Energiezufuhr erlaubt. Gemäß der Erfindung kann beispielsweise zumindest ein gasförmiges organisches Amin vorgesehen werden. Insbesondere ist auch Ammoniak($NH_3$)-Gas geeignet. Diesem Gas kann, wie für das Ausführungsbeispiel angenommen, vorteilhaft Wasser ($H_2O$) in Gasform beigemischt sein. Für diesen Reaktionspartner ist aus dem Diagramm der Figur 3 der Grad der Umsetzung U (in %) beispielsweise von $Cu(C_{11}H_{19}O_2)_2$ in Abhängigkeit von der Temperatur ersichtlich. Neben der entsprechenden Kurve I für diesen Reaktionspartner sind zwei weitere Kurven II und III eingetragen. Diese Kurven ergeben sich für die Fälle, daß reines Wassergas als Reaktionspartner vorgesehen wird (Kurve II) bzw. daß auf einen besonderen Reaktionspartner überhaupt verzichtet wird (Kurve III). Wie aus dem Diagramm der Figur zu entnehmen ist, führt der erfindungsgemäß vorgesehene Reaktionspartner dazu, daß vorteilhaft bei einer verhältnismäßig niedrigen Reaktionstemperatur ein fast vollständiger Umsatz mit dem Cu-Chelat zu erreichen ist. Ein entsprechender Sachverhalt ergibt sich auch für die Chelate der anderen metallischen Komponenten des gewählten Stoffsystems.

Der erfindungsgemäß vorgesehene Reaktionspartner aus gasförmigem $H_2O/NH_3$ wird in einer Kammer 8 ebenfalls dosiert einem Trägergasstrom 9 wie z.B. aus Argon beigefügt. Das so entstandene Gasgemisch sei nachfolgend als "Reaktionskomponente" 10 bezeichnet. Die Beimischung dieser Reaktionskomponente zu dem Gasgemisch 5 beispielsweise im Bereich 7 soll dabei unter Zumischbedingungen erfolgen, bei denen noch keine wesentlichere Reaktion mit den verdampften Ausgangsverbindungen eintritt. Es ergibt sich somit ein in Figur 1 mit 11 bezeichnetes Reaktionsgasgemisch. Dieses Reaktionsgasgemisch setzt sich gemäß dem gewählten Ausführungsbeispiel aus den verdampften Diketonaten der metallischen Ausgangselemente Y, Ba und Cu, dem $H_2O/NH_3$-Gasgemisch der Reaktionskomponente sowie dem Trägergas Ar zusammen. Die Konzentrationswerte der Diketonate im Reaktionsgasgemisch 11, die die Zusammensetzung der abzuscheidenden supraleitenden Hoch-$T_c$-Oxidkeramik in jedem Fall, auch bei nur teilweise, aber reproduzierbarer Umsetzung, bestimmen, werden über den Partialdruck bei vorgegebener Temperatur und kontrolliertem Trägergasfluß eingestellt.

4. Verfahrensschritt

(Chemische Gasphasenreaktion)

Das Reaktionsgasgemisch 11 wird gemäß Figur 1 schließlich in einen Reaktionsraum 12 geleitet, in dem sich ein zu beschichtendes Substrat befindet. Dieses Substrat kann beispielsweise in dem Reaktionsraum 12 ortsfest angeordnet sein oder, insbesondere im Fall einer kontinuierlichen Beschichtung von z.B. band- oder rohrförmigen Substraten, kontinuierlich durch diesen Reaktionsraum geführt werden. In dem Reaktionsraum sind dabei Reaktionsbedingungen erfüllt, die die gewünschte Umsetzung zu der supraleitenden Hoch-$T_c$-Oxidkeramik auf dem Substrat gewährleisten. Diese Umsetzung kann durch einstufige Energiezufuhr, insbesondere durch entsprechende Temperaturverhältnisse, erreicht werden. Dann setzen sich die verdampften Ausgangsverbindungen und der gasförmige Reaktionspartner unter Ausbildung des gewünschten Supraleitermaterials bei diesen Temperaturverhältnissen in einem Prozeß um. Daneben ist auch eine mehrstufige Energiezufuhr möglich. Gemäß diesem Weg werden die verdampften Ausgangsverbindungen und der gasförmige Reaktionspartner zunächst in Oxide der metallischen Komponenten des Supraleitermaterials überführt. Hieran schließt sich dann eine weitere Stufe an, in der sich diese Oxide der metallischen Komponenten bei entsprechender Energiezufuhr zu dem gewünschten Supraleitermaterial umsetzen. Im letzten Fall wählt man vorteilhaft für die weitere Stufe eine höhere Temperatur als für die erste Stufe. Gemäß dem gewählten

Ausführungsbeispiel nach Fig. 1 ist ein einstufiger Prozeß angenommen. Hierzu wird vorteilhaft das Substrat auf eine vorbestimmte Temperatur $T_4$ gebracht. Sofern die Reaktion durch eine Temperaturerhöhung eingeleitet werden soll, kann die untere Grenze für $T_4$ vorteilhaft ungefähr bei 250°C liegen.

Besonders günstig für die Präparation der supraleitenden Oxidkeramik oder der zugrundeliegenden Oxide des genannten Stoffsystems innerhalb des Reaktionsraumes 12 sind eine Hydrolyse und Dehydratisierung in Gegenwart von Ammoniak ($NH_3$) oder einem gasförmigen Amin. $NH_3$ bzw. Amin beeinflussen nämlich vorteilhaft die Geschwindigkeit der Hydrolysereaktion, ohne dabei verbraucht zu werden. Die quasi katalytische Wirkung von $NH_3$ bzw. Amin kann gemäß dem folgenden Reaktionsschema beschrieben werden:

$$Me^{n+}(R_1COCHCOR_2)_n + n\ NH_3 + n\ H_2O \longrightarrow Me(OH)_n + n\ NH_4(R_1COCHCOR_2)$$

$$n\ NH_4(R_1COCHCOR_2) \longrightarrow n\ NH_3 + n\ H(R_1COCHCOR_2)$$

$$Me(OH)_n \longrightarrow MeO_{n/2} + n/2\ H_2O$$

---

$$Me^{n+}(R_1COCHCOR_2)_n + n/2\ H_2O \xrightarrow{NH_3} MeO_{n/2} + n\ H(R_1COCHCOR_2)$$

Me sind dabei die metallischen Ausgangskomponenten Me1, Me2 und Cu des Stoffsystems. Bei $R_1$ und $R_2$ handelt es sich um bekannte Kohlenwasserstoffreste. In Figur 1 ist ferner das sich bei der vorstehenden Reaktion bildende, aus dem Reaktionsraum 12 abzuführende Abgas mit 13 bezeichnet.

Abweichend von dem dargestellten Ausführungsbeispiel kann gegebenenfalls auch eine kombinierte Reaktion vorgesehen werden, bei der eine Hydrolyse und Oxidation gleichzeitig stattfinden. Eine solche kombinierte Reaktion ist insbesondere dann erforderlich, wenn sich die Sauerstoff-Stöchiometrie der herzustellenden supraleitenden Hoch-$T_c$-Phase des gewählten Stoffsystems nicht anderweitig erhalten läßt. In einem solchen Fall wäre beispielsweise während des 3. Verfahrensschrittes dem Gasgemisch 5 aus den Diketonaten der metallischen Ausgangskomponenten und Argon im Bereich 7 zur Komplettierung neben dem Gemisch $H_2O/NH_3$ noch zusätzlich $O_2$ zuzuführen. Daneben ist auch eine $O_2$-Zufuhr direkt in den Reaktionsraum 12 bzw. eine $O_2$-Atmosphäre in diesem Raum möglich.

Gegebenenfalls kann man sogar auch die Beimischung des Reaktionspartners 10 nicht außerhalb des Reaktionsraumes 12 in dem Bereich 7 vornehmen, sondern die Reaktionskomponenten wie $H_2O$ und $NH_3$ sowie gegebenenfalls $O_2$ direkt mittels eines Trägergasstromes in den Reaktionsraum einleiten.

Neben der erwähnten Temperaturerhöhung als Energiezufuhr zur Einleitung der gewünschten Reaktion zur Ausbildung bzw. Abscheidung des Supraleitermaterials in dem Reaktionsraum 12 auf einem Substrat sind ebensogut auch andere bekannte Arten der Energiezufuhr, z.B. mittels eines Lasers, für das erfindungsgemäße Verfahren geeignet.

Gemäß dem für das Verfahrensschema nach Figur 1 gewählten Ausführungsbeispiel wurde davon ausgegangen, daß das herzustellende Supraleitermaterial dem vierkomponentigen Stoffsystem Me1-Me2-Cu-O zuzurechnen ist. Das erfindungsgemäße Verfahren ist jedoch ebensogut auch für andere oxidkeramische Supraleitermaterialien mit hoher Sprungtemperatur geeignet, sofern sich ihre Ausgangskomponenten über eine Hydrolyse von verdampfbaren Ausgangsverbindungen zusammen mit dem zusätzlichen gasförmigen Reaktionspartner zu dem gewünschten Material umsetzen lassen.

Wie bereits erwähnt, sind darüber hinaus neben $NH_3$ als Reaktionspartner 10 für das erfindungsgemäße Verfahren ebensogut auch gasförmige organische Amine geeignet. Hierbei handelt es sich um Verbindungen, die sich vom $NH_3$ dadurch ableiten lassen, daß man in bekannter Weise mindestens eines seiner H-Atome durch Kohlenwasserstoffreste ersetzt. Ein entsprechendes Ausführungsbeispiel wäre z.B. das Dimethylamin ($CH_3 * NH * CH_3$).

## Patentansprüche

1. Verfahren zur Herstellung mindestens einer Schicht aus einem oxidkeramischen Supraleitermaterial eines metallische Komponenten und Sauerstoff enthaltenden Stoffsystems mit hoher Sprungtemperatur auf einem Substrat mittels CVD-Prozeß, wobei die folgenden Verfahrensschritte durchgeführt werden:

a) Als Ausgangsmaterialien werden jeweils mindestens eine verdampfbare Verbindung jeder der metallischen Komponenten des Stoffsystems vorgesehen,

b) jede dieser Ausgangsverbindungen wird bei einer vorbestimmten Temperatur und mit einem vorbestimmten Partialdruck verdampft,

c) es wird zusätzlich mindestens ein gasförmiger, mit den verdampften Ausgangsverbindungen reaktionsfähiger Reaktionspartner vorgesehen,

d) die verdampften Ausgangsverbindungen sowie der mindestens eine gasförmige Reaktionspartner werden jeweils mittels eines Trägergasstromes so dosiert, daß bei einem anschließenden Zusammenführen der so gebildeten Gasströme zu einem Gasgemisch ein Verhältnis der metallischen Komponenten eingestellt wird, das der Zusammensetzung des Supraleitermaterials angepaßt ist,

und

e) zur Ausbildung des gewünschten Supraleitermaterials werden die Reaktionsbedingungen für eine Reaktion der oder mit den verdampften Ausgangsverbindungen und dem mindestens einen Reaktionspartner durch Energiezufuhr eingestellt,

wobei der dem Gasgemisch zugeführte gasförmige Reaktionspartner Ammoniak oder ein organisches Amin zumindest enthält.

2. Verfahren nach Anspruch 1, **dadurch gekennzeichnet,** daß die Reaktion unter Sauerstoffzufuhr erfolgt.

3. Verfahren nach Anspruch 1 oder 2, **dadurch gekennzeichnet,** daß dem Reaktionspartner gasförmiges Wasser zugemischt wird.

4. Verfahren nach einem der Ansprüche 1 bis 3, **dadurch gekennzeichnet,** daß dem Reaktionspartner Sauerstoff-Gas zugemischt wird.

5. Verfahren nach einem der Ansprüche 1 bis 4, **dadurch gekennzeichnet,** daß als Ausgangsverbindungen der metallischen Komponenten Chelate, vorzugsweise β-Diketonate, vorgesehen werden.

6. Verfahren nach einem der Ansprüche 1 bis 5, **dadurch gekennzeichnet,** daß Argon als Trägergas (3a bis 3c, 9) vorgesehen wird.

7. Verfahren nach einem der Ansprüche 1 bis 6, **dadurch gekennzeichnet,** daß die Reaktion der oder mit den Ausgangskomponenten mittels einer Temperaturerhöhung eingeleitet wird.

8. Verfahren nach einem der Ansprüche 1 bis 7, **dadurch gekennzeichnet,** daß die Energiezufuhr einstufig erfolgt, wobei sich die verdampften Ausgangsverbindungen und der Reaktionspartner direkt unter Ausbildung des Supraleitermaterials umsetzen.

9. Verfahren nach einem der Ansprüche 1 bis 7, **dadurch gekennzeichnet,** daß die Energiezufuhr mehrstufig erfolgt, wobei in einer ersten Stufe die verdampften Ausgangsverbindungen und der Reaktionspartner in dem Supraleitermaterial zugrundeliegende Oxide der metallischen Komponenten des Stoffsystems überführt werden und dann in einer weiteren Stufe sich diese Oxide der metallischen Komponenten unter Ausbildung des Supraleitermaterials umsetzen.

10. Verfahren nach Anspruch 9, **dadurch gekennzeichnet,** daß für die weitere Stufe eine höhere Temperatur vorgesehen wird als für die erste Stufe.

## Claims

1. A method of producing at least one layer of an oxide-ceramic superconductor material of a substance system with a high transition temperature containing metallic components and oxygen on a substrate by means of a CVD process, wherein the following steps of the method are carried out:

a) providing as starting materials, at least one vaporisable composition of each of the metallic components of the substance system,

b) vaporizing each of these starting compositions at a predetermined temperature and with a predetermined partial pressure,

c) providing in addition at least one gaseous co-reactant, capable of reacting with the vaporised starting compositions,

d) dosing the vaporised starting compositions as well as the at least one gaseous co-reactant respectively by means of a carrier gas current, so that when the gas currents formed thus are subsequently united in a gas mixture, a metallic component ratio is adjusted, which is adapted to the composition of the superconductor material and

e) to form the desired superconductor material, adjusting the conditions of reaction using an energy supply for a reaction of or with the vaporised starting compositions and the at least one co-reactant, wherein the gaseous co-reactant supplied to the gas mixture contains at least ammonia or an organic amine.

2. A method according to claim 1, characterised in that the reaction takes place during supply of oxygen.

3. A method according to claim 1 or 2, characterised in that gaseous water is admixed with the co-reactant.

4. A method according to claims 1 to 3, characterised in that oxygen gas is admixed with the co-reactant.

5. A method according to one of claims 1 to 4, characterised in that chelates, preferably β-diketones are provided as starting compositions of the metallic components.

6. A method according to one of claims 1 to 5, characterised in that argon is provided as carrier gas (3a to 3c, 9).

7. A method according to one of claims 1 to 6, characterised in that the reaction of or with the starting components is initiated by means of an increase in temperature.

8. A method according to one of claims 1 to 7, characterised in that the supply of energy occurs in a single stage, wherein the vaporised starting compositions and the co-reactant are converted directly while the superconductor material is formed.

9. A method according to one of claims 1 to 7, characterised in that the supply of energy occurs in many stages, wherein in a first stage the vaporised starting compositions and the co-reactant are converted into oxides of the metallic components of the substance system, which oxides are the basis of the superconductor material, and then in a further stage, these oxides of the metallic components are converted with formation of the superconductor material.

10. A method according to claim 9, characterised in that for the further stage a higher temperature is provided than for the first stage.

## Revendications

1. Procédé le fabrication d'au moins une couche d'un matériau supraconducteur en oxydes céramiques d'un système de substances qui comporte des constituants métalliques et de l'oxygène, ayant un point de changement brusque de la conductivité qui est élevé, sur un substrat par un procédé de dépôt chimique en phase vapeur, qui consiste à effectuer les stades de procédé suivants :

a) à prévoir comme matériaux de départ au moins un composé évaporable de chacun des constituants métalliques du système de substances,

b) à évaporer chacun des composés de départ à une température prescrite et sous une pression partielle prescrite,

c) à prévoir, en outre, au moins un partenaire de réaction gazeux, susceptible le réagir sur les composés de départ évaporés,

d) à doser les composés de départ évaporés ainsi que ledit au moins un partenaire de réaction gazeux au moyen d'un courant gazeux porteur de manière à obtenir, lors de la réunion à opérer ensuite des courants gazeux ainsi formés en un mélange gazeux, un rapport des constituants métalliques adapté à la composition du matériau supraconducteur, et

e) pour constituer le matériau supraconducteur souhaité, à régler, par apport d'énergie, les conditions réactionnelles pour une réaction du ou des composés le départ évaporés et dudit au moins un partenaire de réaction, le partenaire de réaction gazeux envoyé au mélange gazeux au moins contenant de l'ammoniac ou une amine organique.

2. Procédé selon la revendication 1 caractérisé par le fait que la réaction a lieu avec apport d'oxygène.

3. Procédé selon la revendication 1 ou 2, caractérisé par le fait qu'on mélange au partenaire de réaction de l'eau sous forme gazeuse.

4. Procédé selon l'une des revendications 1 à 3, caractérisé par le fait que l'on mélange au partenaire de réaction un gaz à teneur en oxygène.

5. Procédé selon l'une des revendications 1 à 4, caractérisé par le fait que l'on prévoit, en tant que composés de départ des constituants métalliques, des chélates, de préférence des β-dicétones.

6. Procédé selon l'une des revendications 1 à 5, caractérisé par le fait que l'Argon est prévu en tant que gaz porteur (3a à 3c, 9).

7. Procédé selon l'une des revendications 1 à 6, caractérisé par le fait que la réaction des constituants de départ ou la réaction avec ces derniers, débute à l'aide d'un accroissement de la température.

8. Procédé selon l'une des revendications 1 à 7, caractérisé par le fait que l'apport en énergie a lieu suivant un palier unique, étant noté que les composants de départ évaporés et le partenaire de réaction réagissent directement avec formation du matériau à supraconduction.

9. Procédé selon l'une des revendications 1 à 7, caractérisé par le fait que l'apport d'énergie a lieu en plusieurs paliers, étant noté que dans un premier palier les composés de départ évaporés et le partenaire de réaction sont transformés en des oxydes des composants métalliques du système de substances, qui sont à la base du matériau supraconducteur et que, dans un second palier, ces oxydes des composants métalliques

réagissent, avec formation du matériau matériau supraconducteur.

10. Procédé selon la revendication 9, caractérisé par le fait qu'il est prévu, pour ce second palier, une température supérieure à celle qui est prévue pour ledit premier palier.

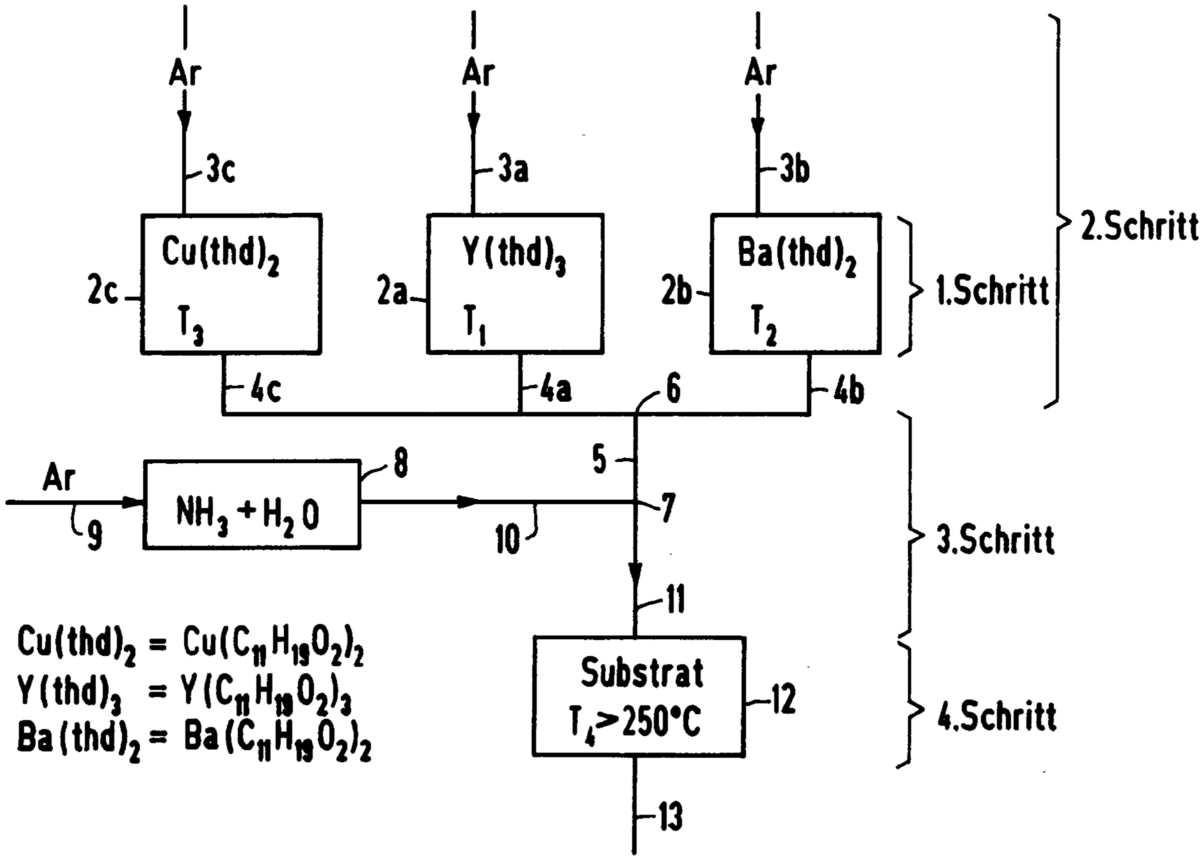
Ar
Ar
Ar
3c
3a
3b
Cu(thd)2 T3
Y(thd)3 T1
Ba(thd)2 T2
2c
2a
2b
1.Schritt
2.Schritt
4c
4a
6
4b
Ar
NH3 + H2O
8
5
7
9
10
3.Schritt
11
Cu(thd)2 = Cu(C11H19O2)2
Y(thd)3 = Y(C11H19O2)3
Ba(thd)2 = Ba(C11H19O2)2
Substrat T4>250°C
12
4.Schritt
13

FIG 1

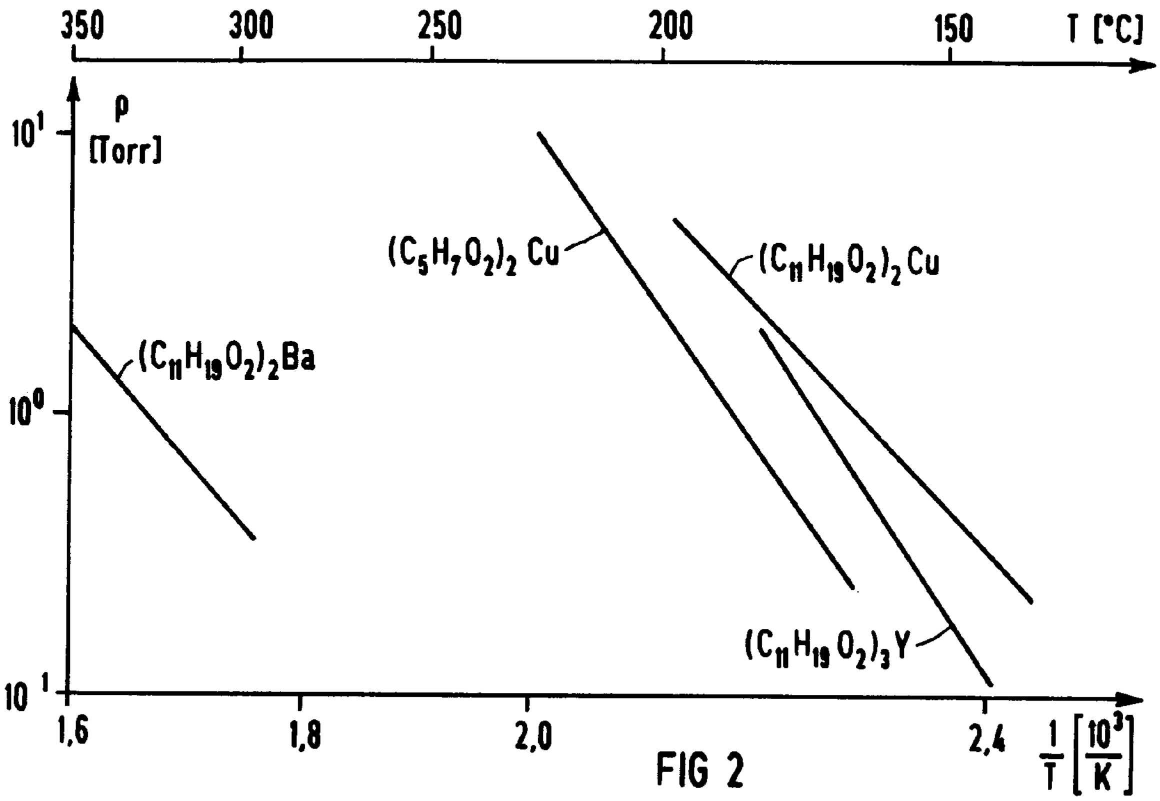
350
300
250
200
150
T [°C]
p
[Torr]
$10^1$
$10^0$
$10^{-1}$
$(C_5H_7O_2)_2$ Cu
$(C_{11}H_{19}O_2)_2$ Cu
$(C_{11}H_{19}O_2)_2$Ba
$(C_{11}H_{19}O_2)_3$Y
1,6
1,8
2,0
2,4
$\frac{1}{T}\left[\frac{10^3}{K}\right]$

FIG 2

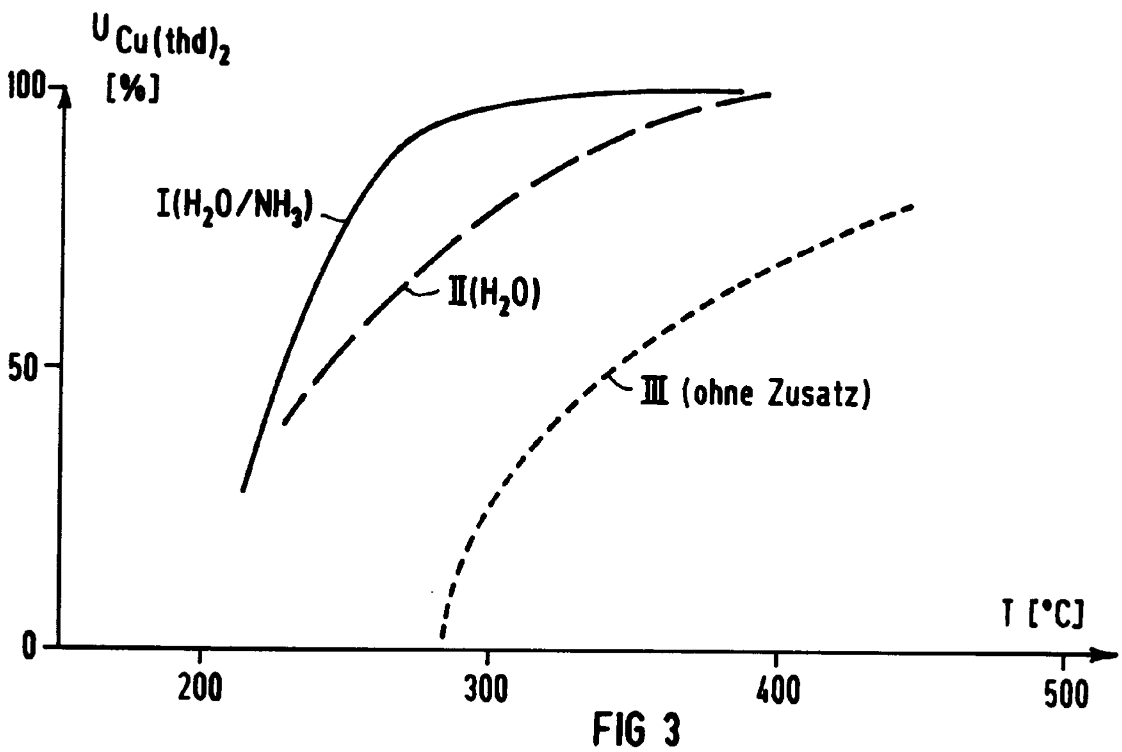
$U_{Cu(thd)_2}$
[%]
100
50
0
I($H_2O/NH_3$)
II($H_2O$)
III (ohne Zusatz)
T [°C]
200
300
400
500

FIG 3